# EUROPÄISCHE PATENTSCHRIFT

(11) **EP 3 017 511 B1**
(45) Veröffentlichungstag und Bekanntmachung des Hinweises auf die Patenterteilung: **30.01.2019**
(21) Anmeldenummer: 14796527.1
(22) Anmeldetag: 13.11.2014
(51) Int. Cl.: H01R 13/52, H01R 12/62, H01R 43/00, H05K 5/06

(54) **VERBINDUNGSVORRICHTUNG ELEKTRISCHER LEITUNGEN MIT ELEKTRISCHEN KONTAKTEN**
CONNECTING DEVICE FOR CONNECTING ELECTRICAL LINES TO ELECTRICAL CONTACTS
DISPOSITIF DE LIAISON DE LIGNES ÉLECTRIQUES À DES CONTACTS ÉLECTRIQUES

(30) Priorität: 06.12.2013 DE 102013225143
(43) Veröffentlichungstag der Anmeldung: 11.05.2016
(73) Patentinhaber: Conti Temic microelectronic GmbH, 90411 Nürnberg (DE)
(72) Erfinder: BÄUMEL, Hermann, 92318 Neumarkt / Opf. (DE); WIECZOREK, Matthias, 91233 Neunkirchen am Sand (DE)
(74) Vertreter: Bonn, Roman Klemens
(86) Internationale Anmeldenummer: PCT/EP2014/074496
(87) Internationale Veröffentlichungsnummer: WO 2015/082188

(56) Entgegenhaltungen:
- WO-A1-2008/049724
- DE-A1-102010 062 653
- DE-C1- 10 051 945
- US-A- 4 674 511

## Beschreibung

Die Erfindung betrifft eine Verbindungsvorrichtung zur elektrischen Verbindung elektrischer Leitungen mit elektrischen Kontakten sowie ein Verfahren zu deren Herstellung.

Elektronische Geräte, z.B. Steuergeräte, enthalten in der Regel eine Vielzahl von elektronischen Komponenten, die mit anderen Komponenten außerhalb des Geräts elektrisch verbunden sind. Die elektrischen Verbindungen müssen oft vor Umwelteinflüssen und mechanischen Einflüssen geschützt werden. Beispielsweise im automobilen Getriebe- und Motorbau werden sowohl am als auch im Getriebe oder Motor elektrische Verbindungen eingesetzt, die vor aggressiven Medien wie Ölen oder Gasen sowie vor Spänen geschützt werden müssen.

Aus der WO 2008/049724 A1 ist ein Gehäuse für ein elektronisches Steuergerät bekannt, welches mindestens zwei Gehäuseteile aufweist, die mindestens einen Gehäuseboden, einen Gehäusedeckel und eine elektronische Verbindung zwischen im Gehäuseinnenraum angeordneten Bauteilen und außerhalb des Gehäuses liegenden Komponenten umfasst, die auf dem Gehäuseboden fixiert sind. Der Gehäusedeckel ist direkt auf der elektronischen Verbindung aufgelötet und dichtet eine Durchführung der elektronischen Verbindung hermetisch ab.

Des Weiteren ist aus der US 4 674 511 A ein Signalleiter einer medizinischen Elektrode bekannt, welche für Röntgenstrahlung durchlässig ist. Der Signalleiter umfasst eine Platte aus einem flexiblen Material und einen elektrisch leitfähigen Lack, welcher auf eine Seite der Platte aufgebracht ist.

Der Erfindung liegt die Aufgabe zu Grunde, eine verbesserte Verbindungsvorrichtung zur elektrischen Verbindung elektrischer Leitungen mit elektrischen Kontakten sowie ein entsprechendes Herstellungsverfahren anzugeben.

Die Aufgabe wird erfindungsgemäß durch die Merkmale des Anspruchs 1 bzw. des Anspruchs 10 gelöst.

Vorteilhafte Ausgestaltungen der Erfindung sind Gegenstand der Unteransprüche.

Eine Verbindungsvorrichtung zur elektrischen Verbindung elektrischer Leitungen mit elektrischen Kontakten umfasst eine flexible Leiterplatte, einen Grundträger und eine Abdeckung. Die elektrischen Leitungen sind auf der flexiblen Leiterplatte angeordnet. Die flexible Leiterplatte weist einen Kontaktierungsbereich auf, in dem wenigstens eine elektrische Leitung elektrisch mit wenigstens einem elektrischen Kontakt verbunden ist. Die elektrischen Kontakte sind auf dem Grundträger angeordnet. Die flexible Leiterplatte ist zwischen dem Grundträger und der Abdeckung angeordnet, wobei der Grundträger und die Abdeckung ein dichtes Gehäuse des Kontaktierungsbereichs bilden.

Durch das von dem Grundträger und der Abdeckung gebildete Gehäuse wird der Kontaktierungsbereich, in dem die elektrischen Leitungen der flexiblen Leiterplatte mit den elektrischen Kontakten verbunden sind, vor der Umgebung, beispielsweise vor aggressiven Medien wie Ölen oder Gasen sowie vor Spänen abgeschirmt. Die Leiterplatte und die Abdeckung sind erfindungsgemäß jeweils aus einem flexiblen Material, insbesondere demselben flexiblen Material, wie zum Beispiel Polyimid oder faserverstärktem Kunststoff. Daher ist zumindest eine physikalische Materialeigenschaft von Leiterplatte und Abdeckung, wie zum Beispiel Längenausdehnungskoeffizient oder Elastizitätsmodul, gleich. Dadurch wird insbesondere erreicht, dass bei Temperaturschwankungen, die in einem Getriebe durchaus zwischen -30°C und +150°C liegen können, im Bereich der Kontaktfläche zwischen Leiterplatte und Abdeckung keine zusätzlichen Scherkräfte auftreten, die zu Spalt- oder Rissbildung und somit zu Undichtigkeiten im Gehäuse führen können.

Dadurch werden die elektrischen Verbindungen der elektrischen Leitungen mit den elektrischen Kontakten vor schädigenden Umgebungseinflüssen vorteilhaft geschützt, so dass diese Verbindungen beispielsweise auch in Getrieben oder Motoren von Fahrzeugen eingesetzt werden können.

Eine Ausgestaltung der Erfindung sieht vor, dass die flexible Leiterplatte elektrische Leitungen und eine elektronische Schaltung, insbesondere eine Getriebesteuereinheit mit aktiven und passiven elektronischen Komponenten umfasst. Dadurch ist die Steuereinheit zum einen mediendicht in einem Gehäuse geschützt und andererseits über die Leiterplatte mit Komponenten in der Peripherie des Gehäuses signal- bzw. energieübertragend elektrisch verbunden.

Eine weitere Ausgestaltung der Erfindung sieht vor, dass die flexible Leiterplatte einen Verbindungsbereich aufweist, der stoffschlüssig mit dem Grundträger und der Abdeckung verbunden ist und den Kontaktierungsbereich umgibt. Dadurch wird die flexible Leiterplatte zwischen dem Grundträger und der Abdeckung fixiert, ohne den Kontaktierungsbereich selbst fest mit dem Grundträger oder der Abdeckung zu verbinden, so dass der Kontaktierungsbereich weiterhin in dem von dem Grundträger und der Abdeckung gebildeten Gehäuse flexibel bleibt und Toleranzen ausgleichbar sind, die herstellungsbedingt oder durch Spannungen oder Temperaturänderungen zwischen den elektrischen Leitungen bzw. der Leiterplatte und den elektrischen Kontakten, dem Grundträger und/oder der Abdeckung auftreten können
Bei dieser Ausgestaltung der Erfindung wird der Verbindungsbereich vorzugsweise jeweils durch Lamination oder Verklebung oder Verschweißung stoffschlüssig mit dem Grundträger und der Abdeckung verbunden. Dies ermöglicht vorteilhaft eine dichte Verbindung der flexiblen Leiterplatte mit dem Grundträger und der Abdeckung, so dass das Innere des von dem Grundträger und der Abdeckung gebildeten Gehäuses gegen die Umgebung abgeschirmt ist. Insbesondere beim Laminationsprozess bei Raumtemperatur ist es von Vorteil, diesen Prozess unter Vakuumbedingungen durchzuführen, da sonst die Gefahr besteht, dass sich die flexible Leiterplatte aufbaucht.

Zur Vermeidung von Scherkräften auf die stoffschlüssige Verbindung zwischen der Abdeckung und der Leiterplatte, und damit zur Vermeidung von Undichtigkeiten weist die Abdeckung vorteilhafterweise eine Ausgleichskontur zum Ausgleichen vor allem von temperaturabhängigen Volumenschwankungen auf.

Eine weitere Ausgestaltung der Erfindung sieht vor, dass die Abdeckung aus einem Kunststoff oder einer Folie gefertigt ist. Die Wahl des Materials wird dabei den jeweiligen Anforderungen angepasst, die von der Umgebung gestellt werden, in der die Verbindungsvorrichtung eingesetzt werden soll.

Der Grundträger ist vorzugsweise aus einem Kunststoff gefertigt. Dies erleichtert vorteilhaft die Anordnung der elektrischen Kontakte auf dem Grundträger.

Vorzugsweise wird wenigstens eine elektrische Leitung mit wenigstens einem elektrischen Kontakt durch Löten, Kleben, Schweißen und/oder Einpressen verbunden, da dies vorteilhaft stabile elektrische Verbindungen zwischen elektrischen Leitungen und elektrischen Kontakten ermöglicht.

Vorzugsweise weist die flexible Leiterplatte ferner einen Außenbereich auf, der außerhalb des durch den Grundträger und die Abdeckung gebildeten Gehäuses des Kontaktierungsbereichs angeordnet ist und mittels dessen wenigstens eine elektrische Leitung aus diesem Gehäuse herausgeführt ist. Dadurch können elektrische Leitungen und elektrische Kontakte der Verbindungsvorrichtung vorteilhaft von außen, d.h. bei geschlossenem Gehäuse, elektrisch kontaktiert werden.

Beim Verfahren zur Herstellung einer elektrischen Verbindung elektrischer Leitungen mit elektrischen Kontakten werden zunächst ein Grundträger mit elektrischen Kontakten, eine flexible Leiterplatte mit elektrischen Leitungen und einem Kontaktierungsbereich sowie eine insbesondere hutförmige Abdeckung mit einem randseitigen Hutkrempenabschnitt bereit gestellt.

Gleichzeitig mit dem Herstellen einer stoffschlüssigen Verbindung zwischen der Leiterplatte und dem Grundträger wird vorzugsweise eine elektrische Verbindung zwischen den elektrischen Kontakten auf dem Grundträger und dem Kontaktierungsbereich der Leiterplatte hergestellt, wobei wenigstens ein elektrischer Kontakt mit wenigstens einer elektrischen Leitung verbunden wird.

Anschließend wird mindestens eine elektronische Komponente, vorzugsweise eine gesamte elektronische Schaltung, auf dem Kontaktierungsbereich der Leiterplatte angeordnet und mit den elektrischen Leitungen der Leiterplatte elektrisch verbunden. Abschließend wird die Abdeckung auf die Leiterplatte platziert und mit dieser stoffschlüssig mediendicht verbunden.

Erfindungsgemäß sind die Leiterplatte und die Abdeckung aus einem flexiblen Material, wobei zumindest eine physikalische Materialeigenschaft wie Längenausdehnung und/oder Elastizitätsmodul von Leiterplatte und Abdeckung gleich sind. Dadurch wird insbesondere erreicht, dass bei Temperaturschwankungen im Kontaktbereich zwischen Leiterplatte und Abdeckung keine zusätzlichen Scherkräfte auftreten, die zu Spalt- und Rissbildung und somit zu Undichtigkeiten in der Verbindungsvorrichtung führen können.

Das Herstellen der stoffschlüssigen Verbindung zwischen der Abdeckung und der Leiterplatte geschieht zum Beispiel durch Kleben oder Laminieren. Insbesondere beim Laminierprozess bei Raumtemperatur ist es von Vorteil, diesen Prozess unter Vakuumbedingungen durchzuführen, da sonst die Gefahr besteht, dass sich die flexible Leiterplatte aufbaucht und der Verbindungsbereich undicht wird.

Weitere Merkmale, Vorteile und Einzelheiten sind der nachfolgenden Beschreibung entnehmbar, in der bevorzugte Ausführungsbeispiele anhand der Figuren näher erläutert werden. Es zeigen:
- Fig. 1: eine perspektivische Explosionsdarstellung einer Verbindungsvorrichtung zur elektrischen Verbindung elektrischer Leitungen mit elektrischen Kontakten, und
- Fig. 2: einen Schnitt durch eine Verbindungsvorrichtung zur elektrischen Verbindung elektrischer Leitungen mit elektrischen Kontakten.

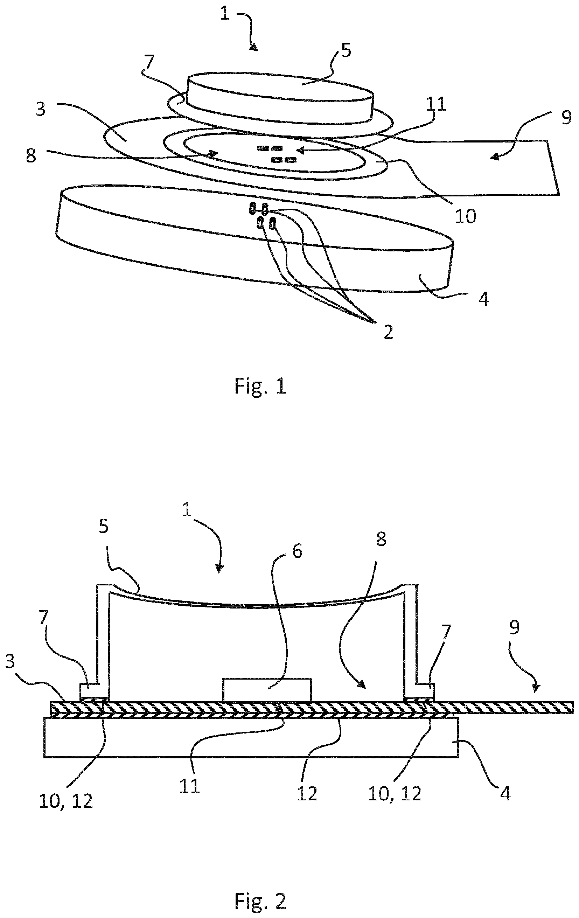

Fig. 1 zeigt eine perspektivische Explosionsdarstellung einer Verbindungsvorrichtung 1 zur elektrischen Verbindung elektrischer Leitungen mit elektrischen Kontakten 2. Die Verbindungsvorrichtung 1 umfasst eine flexible Leiterplatte 3, einen Grundträger 4 und eine Abdeckung 5.

Der Grundträger 4 ist als ein im Wesentlichen zylinderförmiger Sockel ausgebildet und beispielsweise aus einem Kunststoff gefertigt. Eine der flexiblen Leiterplatte 3 zugewandte Deckfläche der Oberfläche des Grundträgers 4 weist mittig die elektrischen Kontakte 2 auf. In Fig. 1 sind die elektrischen Kontakte 2 als metallische Anschlussstifte ausgebildet. Alternativ können die elektrischen Kontakte 2 auch durch ein Stanzgitter realisiert sein.

Die Abdeckung 5 ist im in der Figur dargestellten Ausführungsbeispiel hutförmig ausgebildet und weist als umlaufenden Dichtbereich einen Hutkrempenabschnitt 7 auf, dessen Unterseite der flexiblen Leiterplatte 3 zugewandt ist. Die Abdeckung 5 ist beispielsweise aus einem Kunststoff oder einer Folie gefertigt.

Die flexible Leiterplatte 3 trägt die in Fig. 1 nicht näher dargestellten elektrischen Leitungen in Form von Leiterbahnen. Die flexible Leiterplatte 3 weist einen zwischen dem Grundträger 4 und der Abdeckung 5 angeordneten Innenbereich 8, der im Wesentlichen kreisscheibenförmig ausgebildet ist, und einen Außenbereich 9, der sich an den Innenbereich 8 anschließt, auf.

Der Innenbereich 8 der flexiblen Leiterplatte 3 weist einen kreisringförmigen Verbindungsbereich 10 auf, der auf einer Seite stoffschlüssig mit der Deckfläche des Grundträgers 4 und auf der anderen Seite stoffschlüssig mit der Unterseite des Hutkrempenabschnitts 7 der Abdeckung 5 verbunden ist. Die stoffschlüssigen Verbindungen des Verbindungsbereichs 10 mit dem Grundträger 4 und der Abdeckung 5 werden dabei jeweils beispielsweise durch Lamination, Verklebung oder Verschweißung hergestellt. Insbesondere wenn der Laminationsprozess bei Raumtemperatur durchgeführt wird, ist es von Vorteil, diesen Prozess unter Vakuumbedingungen durchzuführen, da sich sonst die flexible Leiterplatte 3 aufbauchen und es dadurch zu Undichtigkeiten im Verbindungsbereich 10 kommen kann.

Besonders beim Verkleben des Verbindungsbereichs 10 mit dem Grundträger 4 und der Abdeckung 5 können durch das Layout bedingte Unebenheiten, wie zum Beispiel Berge und Täler der Leiterbahnen des Folienleiters 3 durch das flexible Material der Abdeckung 5 und der Leiterplatte 3 in Verbindung mit dem Kleber ausgeglichen und dadurch Undichtigkeiten in diesem Bereich vermieden werden.

Der Verbindungsbereich 10 der flexiblen Leiterplatte 3 umgibt einen Kontaktierungsbereich 11, in dem elektrische Leitungen der flexiblen Leiterplatte 3 elektrisch mit elektrischen Kontakten 2 verbunden sind, wobei eine Verbindung einer elektrischen Leitung mit einem elektrischen Kontakt 2 vorzugsweise durch Löten hergestellt wird.

Der Grundträger 4 und die Abdeckung 5 bilden ein dichtes Gehäuse für den Kontaktierungsbereich 11 der flexiblen Leiterplatte 3. Der Außenbereich 9 der flexiblen Leiterplatte 3 befindet sich außerhalb dieses Gehäuses und führt elektrische Leitungen aus dem Gehäuse heraus.

Fig. 2 zeigt einen Schnitt durch eine Verbindungsvorrichtung, wobei auf der Leiterplatte 3 im Kontaktierungsbereich 11 eine elektronische Schaltung 6, insbesondere eine Getriebesteuereinheit mit aktiven und passiven elektronischen Komponenten angeordnet ist. Dadurch ist die elektronische Schaltung 6 zum einen mediendicht in einem Gehäuse geschützt angeordnet und andererseits über die Leiterplatte 3 mit Komponenten in der Peripherie des Gehäuses signal- bzw. energieübertragend elektrisch verbunden.

Die flexible Leiterplatte 3 ist hier ganzflächig mittels der stoffschlüssigen Verbindung 12 an den Grundträger 4 gefügt. Die Abdeckung 5 ist mit seinem als Hutkrempenabschnitt 7 ausgeführten umlaufenden Dichtbereich mittels der stoffschlüssigen Verbindung 12 an den Verbindungsbereich 10 der Leiterplatte gefügt.

Der der Leiterplatte 3 gegenüberliegende Abschnitt der Abdeckung 5 ist in Fig. 2 konkav-konvex ausgebildet. Durch diese Form und die Materialeigenschaften der flexiblen Abdeckung 5 können temperaturschwankungsbedingte Volumenänderungen im Gehäuse aus Abdeckung 5 und Grundträger 4 und daraus resultierende und Undichtigkeiten verursachende Scherkräfte im Verbindungsbereich 10 der Leiterplatte in besonderem Maß vermieden werden.

### BEZUGSZEICHENLISTE

- 1: Verbindungsvorrichtung
- 2: elektrischer Kontakt
- 3: flexible Leiterplatte
- 4: Grundträger
- 5: Abdeckung
- 6: elektronische Schaltung
- 7: Hutkrempenabschnitt
- 8: Innenbereich
- 9: Außenbereich
- 10: Verbindungsbereich
- 11: Kontaktierungsbereich
- 12: stoffschlüssige Verbindung

## Patentansprüche

1. Verbindungsvorrichtung (1) zur elektrischen Verbindung elektrischer Leitungen mit elektrischen Kontakten (2), wobei
- die Verbindungsvorrichtung (1) einen Grundträger (4), eine flexible Leiterplatte (3) und eine Abdeckung (5) umfasst,
- die flexible Leiterplatte (3) einen Kontaktierungsbereich (11) aufweist, in dem wenigstens eine elektrische Leitung elektrisch mit wenigstens einem elektrischen Kontakt (2) verbunden ist,
- der elektrische Kontakt (2) auf dem Grundträger (4) angeordnet ist,
- die flexible Leiterplatte (3) teilweise zwischen dem Grundträger (4) und der Abdeckung (5) angeordnet ist, wobei der Grundträger (4) und die Abdeckung (5) ein dichtes Gehäuse um den Kontaktierungsbereich (11) bilden,
- die flexible Leiterplatte (3) einen Außenbereich (9) aufweist, der außerhalb des durch den Grundträger (4) und die Abdeckung (5) gebildeten Gehäuses um den Kontaktierungsbereich (11) angeordnet ist, und
- wenigstens eine elektrische Leitung der flexiblen Leiterplatte (3) über den Außenbereich (9) aus diesem Gehäuse herausgeführt ist,
**dadurch gekennzeichnet, dass** die Leiterplatte (3) und die Abdeckung (5) jeweils aus einem flexiblen Material sind, wobei zumindest eine der folgenden physikalischen Materialeigenschaften, Längenausdehnungskoeffizient oder Elastizitätsmodul, von Leiterplatte (3) und Abdeckung (5) gleich ist.

2. Verbindungsvorrichtung (1) nach Anspruch 1, **dadurch gekennzeichnet, dass** die flexible Leiterplatte (3) elektrische Leitungen und mindestens eine elektronische Schaltung (6) trägt.

3. Verbindungsvorrichtung (1) nach Anspruch 1 oder 2, **dadurch gekennzeichnet, dass** die flexible Leiterplatte (3) einen Verbindungsbereich (10) aufweist, der stoffschlüssig mit dem Grundträger (4) und der Abdeckung (5) verbunden ist und den Kontaktierungsbereich (11) umgibt.

4. Verbindungsvorrichtung (1) nach Anspruch 3, **dadurch gekennzeichnet, dass** der Verbindungsbereich (10) jeweils durch Lamination oder Verklebung oder Verschweißung stoffschlüssig mit dem Grundträger (4) und der Abdeckung (5) verbunden ist.

5. Verbindungsvorrichtung (1) nach Anspruch 4, **dadurch gekennzeichnet, dass** die stoffschlüssige Verbindung zwischen der Abdeckung (5) und der Leiterplatte (3) bei Raumtemperatur unter Vakuum hergestellt ist.

6. Verbindungsvorrichtung (1) nach einem der vorhergehenden Ansprüche, **dadurch gekennzeichnet, dass** die Abdeckung (5) zur Vermeidung von Scherkräften auf die stoffschlüssige Verbindung zwischen der Abdeckung (5) und der Leiterplatte (3) eine Ausgleichskontur aufweist.

7. Verbindungsvorrichtung (1) nach einem der vorhergehenden Ansprüche, **dadurch gekennzeichnet, dass** die Abdeckung (5) aus einem Kunststoff oder einer Folie gefertigt ist.

8. Verbindungsvorrichtung (1) nach einem der vorhergehenden Ansprüche, **dadurch gekennzeichnet, dass** der Grundträger (4) aus Kunststoff oder Metall gefertigt ist.

9. Verbindungsvorrichtung (1) nach einem der vorhergehenden Ansprüche, **dadurch gekennzeichnet, dass** wenigstens eine elektrische Leitung mit wenigstens einem elektrischen Kontakt (2) durch Löten und/oder Kleben und/oder Schweißen und/oder Einpressen verbunden ist.

10. Verfahren zur Herstellung einer elektrischen Verbindung elektrischer Leitungen mit elektrischen Kontakten (2),
wobei die Verbindungsvorrichtung (1) nach Anspruch 1, einen Grundträger (4), eine Leiterplatte (3) aus einem flexiblen Material und eine Abdeckung (5) aus einem flexiblen Material umfasst,
mit den Schritten:
- Bereitstellen eines Grundträgers (4) mit elektrischen Kontakten (2),
- Bereitstellen einer flexiblen Leiterplatte (3) mit elektrischen Leitungen und einem Kontaktierungsbereich (11),
- Bereitstellen einer hutförmigen Abdeckung (5) mit einem Hutkrempenabschnitt (7),
- Herstellen einer stoffschlüssigen Verbindung zwischen der Leiterplatte (3) und dem Grundträger (4), und
- gleichzeitiges Herstellen einer elektrischen Verbindung zwischen den elektrischen Kontakten (2) auf dem Grundträger (4) und dem Kontaktierungsbereich (11) der Leiterplatte (3), wobei wenigstens ein elektrischer Kontakt (2) mit wenigstens einer elektrischen Leitung verbunden wird,
- Anordnen von mindestens einer elektronischen Komponente, insbesondere einer elektronischen Schaltung (6), auf dem Kontaktierungsbereich (11) der Leiterplatte (3),
- Herstellen einer elektrischen Verbindung zwischen der elektronischen Komponente (6) und den elektrischen Leitungen der Leiterplatte (3),
- Herstellen einer stoffschlüssigen Verbindung zwischen der Abdeckung (5) und der Leiterplatte (3), unter Ausbildung eines dichten Gehäuses um den Kontaktierungsbereich (11), wobei
die flexible Leiterplatte (3) einen Außenbereich (9) aufweist, der außerhalb des durch den Grundträger (4) und die Abdeckung (5) gebildeten Gehäuses um den Kontaktierungsbereich (11) angeordnet ist, und
wenigstens eine elektrische Leitung der flexiblen Leiterplatte (3) über den Außenbereich (9) aus diesem Gehäuse herausgeführt wird,
**dadurch gekennzeichnet, dass**
zumindest eine der folgenden physikalischen Materialeigenschaften, Längenausdehnungskoeffizient oder Elastizitätsmodul, von Leiterplatte (3) und Abdeckung (5) gleich ist.

11. Verfahren nach Anspruch 11, **dadurch gekennzeichnet, dass** die stoffschlüssige Verbindung zwischen der Abdeckung (5) und der Leiterplatte (3) bei Raumtemperatur unter Vakuum hergestellt wird.

## Claims

1. Connecting device (1) for electrically connecting electrical lines to electrical contacts (2), wherein
- the connecting device (1) comprises a base support (4), a flexible printed circuit (3) and a cover (5),
- the flexible printed circuit (3) has a contact-making region (11) in which at least one electrical line is electrically connected to at least one electrical contact (2),
- the electrical contact (2) is arranged on the base support (4),
- the flexible printed circuit (3) is arranged in part between the base support (4) and the cover (5), wherein the base support (4) and the cover (5) form a sealed housing around the contact-making region (11),
- the flexible printed circuit (3) has an outer region (9) which is arranged outside the housing around the contact-making region (11),
- at least one electrical line of the flexible printed circuit (3) is routed out of said housing via the outer region (9),
**characterized in that** the printed circuit (3) and the cover (5) are each composed of a flexible material, wherein at least one of the physical material properties, coefficient of linear expansion or modulus of elasticity, of the printed circuit (3) and the cover (5) is identical.

2. Connecting device (1) according to Claim 1, **characterized in that** the flexible printed circuit (3) is fitted with electrical lines and at least one electronic circuit (6).

3. Connecting device (1) according to Claim 1 or 2, **characterized in that** the flexible printed circuit (3) has a connecting region (10) which is cohesively connected to the base support (4) and the cover (5) and surrounds the contact-making region (11).

4. Connecting device (1) according to Claim 3, **characterized in that** the connecting region (10) is cohesively connected to the base support (4) and the cover (5) by lamination or adhesive bonding or welding in each case.

5. Connecting device (1) according to Claim 4, **characterized in that** the cohesive connection between the cover (5) and the printed circuit (3) is established under vacuum at room temperature.

6. Connecting device (1) according to one of the preceding claims, **characterized in that** the cover (5) has a compensation contour in order to avoid shear forces on the cohesive connection between the cover (5) and the printed circuit (3).

7. Connecting device (1) according to one of the preceding claims, **characterized in that** the cover (5) is manufactured from a plastic or a foil/film.

8. Connecting device (1) according to one of the preceding claims, **characterized in that** the base support (4) is manufactured from plastic or metal.

9. Connecting device (1) according to one of the preceding claims, **characterized in that** at least one electrical line is connected to at least one electrical contact (2) by soldering and/or adhesive bonding and/or welding and/or pressing-in.

10. Method for establishing an electrical connection between electrical lines and electrical contacts (2),
wherein the connecting device (1) according to Claim 1 comprises a base support (4), a printed circuit (3) which is composed of a flexible material, and a cover (5) which is composed of a flexible material, comprising the steps of:
- providing a base support (4) which has electrical contacts (2),
- providing a flexible printed circuit (3) which has electrical lines and a contact-making region (11),
- providing a hat-like cover (5) which has a hat brim section (7),
- establishing a cohesive connection between the printed circuit (3) and the base support (4), and
- at the same time establishing an electrical connection between the electrical contacts (2) on the base support (4) and the contact-making region (11) of the printed circuit (3), wherein at least one electrical contact (2) is connected to at least one electrical line,
- arranging at least one electronic component, in particular an electronic circuit (6), on the contact-making region (11) of the printed circuit (3),
- establishing an electrical connection between the electronic component (6) and the electrical lines of the printed circuit (3), and
- establishing a cohesive connection between the cover (5) and the printed circuit (3), to form a sealed housing around the contact-making region (11), wherein
the flexible printed circuit (3) has an outer region (9) which is arranged outside the housing around the contact-making region (11), which housing is formed by the base support (4) and the cover (5), and
at least one electrical line of the flexible printed circuit (3) is routed out of said housing via the outer region (9), **characterized in that**
at least one of the following physical material properties, coefficient of linear expansion or modulus of elasticity, of the printed circuit (3) and the cover (5) is identical.

11. Method according to Claim 10, **characterized in that** the cohesive connection between the cover (5) and the printed circuit (3) is established under vacuum at room temperature.

## Revendications

1. Dispositif de liaison (1) servant à relier électriquement des lignes électriques à des contacts électriques (2), dans lequel
- le dispositif de liaison (1) comprend un support de base (4), une carte de circuit imprimé flexible (3) et un couvercle (5),
- la carte de circuit imprimé flexible (3) comporte une zone de contact (11) dans laquelle au moins une ligne électrique est reliée électriquement à au moins un contact électrique (2),
- le contact électrique (2) est disposé sur le support de base (4),
- la carte de circuit imprimé flexible (3) est disposée en partie entre le support de base (4) et le couvercle (5), dans lequel le support de base (4) et le couvercle (5) forment un boîtier étanche autour de la zone de contact (11),
- la carte de circuit imprimé flexible (3) comporte une zone extérieure (9) qui est disposée à l'extérieur du boîtier formé par le support de base (4) et le couvercle (5) autour de la zone de contact (11), et
- au moins une ligne électrique de la carte de circuit imprimé flexible (3) est extraite dudit boîtier par l'intermédiaire de la zone extérieure (9),
**caractérisé en ce que** la carte de circuit imprimé (3) et le couvercle (5) sont respectivement constitués d'un matériau flexible, dans lequel au moins l'une des propriétés physiques suivantes du matériau, à savoir coefficient de dilatation linéaire ou le module d'élasticité de la carte de circuit imprimé (3) et du couvercle (5), sont identiques.

2. Dispositif de liaison (1) selon la revendication 1, **caractérisé en ce que** la carte de circuit imprimé flexible (3) porte des lignes électriques et au moins un circuit électronique (6).

3. Dispositif de liaison (1) selon la revendication 1 ou 2, **caractérisé en ce que** la carte de circuit imprimé flexible (3) comporte une zone de liaison (10) qui est reliée par complémentarité de matériau au support de base (4) et au couvercle (5) et qui entoure la zone de contact (11).

4. Dispositif de liaison (1) selon la revendication 3, **caractérisé en ce que** la zone de liaison (10) est reliée au support de base (4) et au couvercle (5) par stratification, collage ou soudage.

5. Dispositif de liaison (1) selon la revendication 4, **caractérisé en ce que** la liaison par complémentarité de matériau entre le couvercle (5) et la carte de circuit imprimé (3) est réalisée à température ambiante sous vide.

6. Dispositif de liaison (1) selon l'une des revendications précédentes, **caractérisé en ce que** le couvercle (5) présente un contour de compensation servant à éviter que des forces de cisaillement s'exercent sur la liaison par complémentarité de matériau entre le couvercle (5) et la carte de circuit imprimé (3) .

7. Dispositif de liaison (1) selon l'une des revendications précédentes, **caractérisé en ce que** le couvercle (5) est constitué d'une matière plastique ou d'un film.

8. Dispositif de liaison (1) selon l'une des revendications précédentes, **caractérisé en ce que** le support de base (4) est constitué de matière plastique ou de métal.

9. Dispositif de liaison (1) selon l'une des revendications précédentes, **caractérisé en ce qu'**au moins une ligne électrique est reliée à au moins un contact électrique (2) par brasage et/ou collage et/ou soudage et/ou emboutissage.

10. Procédé servant à établir une liaison électrique entre des conducteurs électriques et des contacts électriques (2),
dans lequel le dispositif de liaison (1) selon la revendication 1 comprend un support de base (4), une carte de circuit imprimé (3) constituée d'un matériau flexible et un couvercle (5) constitué d'un matériau flexible,
comportant les étapes qui consistent à :
- prévoir un support de base (4) comportant des contacts électriques (2),
- prévoir une carte de circuit imprimé flexible (3) comportant des lignes électriques et une zone de contact (11),
- prévoir un couvercle en forme de chapeau (5) comportant une partie de bord de chapeau (7),
- établir une liaison par complémentarité de matériau entre la carte de circuit imprimé (3) et le support de base (4), et
- établir simultanément une liaison électrique entre les contacts électriques (2) du support de base (4) et la zone de contact (11) de la carte de circuit imprimé (3),
dans lequel au moins un contact électrique (2) est relié à au moins une ligne électrique,
- disposer au moins un composant électronique, en particulier un circuit électronique (6), sur la zone de contact (11) de la carte de circuit imprimé (3),
- établir une liaison électrique entre le composant électronique (6) et les lignes électriques de la carte de circuit imprimé (3),
- établir une liaison par complémentarité de matériau entre le couvercle (5) et la carte de circuit imprimé (3), en formant un boîtier étanche autour de la zone de contact (11), dans lequel la carte de circuit imprimé flexible (3) comporte une zone extérieure (9) qui est disposée à l'extérieur du boîtier formé par le support de base (4) et le couvercle (5) autour de la zone de contact (11), et
au moins une ligne électrique de la carte de circuit imprimé flexible (3) est extraite dudit boîtier par l'intermédiaire de la zone extérieure (9), **caractérisé en ce qu'**au moins l'une des propriétés physiques suivantes du matériau, à savoir le coefficient de dilatation linéaire ou le module d'élasticité de la carte de circuit imprimé (3) et du couvercle (5), sont identiques.

11. Procédé selon la revendication 11, **caractérisé en ce que** la liaison par complémentarité de matériau entre le couvercle (5) et la carte de circuit imprimé (3) est réalisée sous vide à température ambiante.
